# EUROPÄISCHE PATENTANMELDUNG

(11) **EP 0 575 804 A2**
(43) Veröffentlichungstag der Anmeldung: **29.12.1993**
(21) Anmeldenummer: 93109118.5
(22) Anmeldetag: 07.06.1993
(51) Int. Cl.: H01L 21/76

(54) **Verfahren zur elektrischen Isolation eines Funktionselementes auf einem Halbleiterbauelement**

(30) Priorität: 22.06.1992 DE 4220315
(71) Anmelder: SIEMENS AKTIENGESELLSCHAFT, D-80333 München (DE)
(72) Erfinder: Schleicher, Lothar, Dipl.-Phys., W-8000 München 83 (DE); Zwicknagl, Peter, Dr., W-7000 Stuttgart 80 (DE); Schöning, Elke, W-8000 München 83 (DE)

(57) **Zusammenfassung**

Verfahren zur elektrischen Isolation eines Funktionselementes auf einem Halbleiterbauelement, bei dem das Funktionselement mittels einer Maske (8) zu einer Mesa (9) rückgeätzt wird, dann ganzflächig mindestens bis zur Höhe dieser Mesa (9) ein Dielektrikum (10) aufgebracht wird, dann die tieferliegenden Anteile dieser Dielektrikumschicht mit Fotolack (11) bedeckt werden, durch Tempern der Fotolack (11) zum Zerfließen und damit zum Einebnen der Oberfläche gebracht wird und schließlich der Fotolack (11) und das Dielektrikum (10) mit gleicher Ätzrate rückgeätzt werden, bis die Mesa freigelegt ist.

## Beschreibung

Die vorliegende Erfindung betrifft ein Verfahren zur elektrischen Isolation eines Funktionselementes, insbesondere eines Transistors, auf einem Halbleiterbauelement, auf dem weitere Funktionselemente integriert sind.

Hetero-Bauelemente auf Halbleitermaterial enthalten zum Teil hochleitfähige Halbleiterschichten, die die gesamte Halbleiterscheibe in einer Dicke von 1 bis 2,5 µm bedecken, einzelne Funktionselemente eines solchen Bauelementes müssen deshalb elektrisch von den übrigen Teilen des Bauelementes isoliert werden. Bisher sind für diese Isolation verschiedene Verfahren bekannt. Durch tiefe Isolationsimplantation z. B. mit B⁺⁺ bei Beschleunigungsspannungen im MV-Bereich oder mit H⁺, O⁺ werden Isolationsbereiche in dem Halbleitermaterial hergestellt. Nachteile dieser Verfahren sind, daß sie prinzipiell nicht für hoch dotierte Schichten anwendbar sind, so daß eine Kombination dieser Implantation mit Rückätzen des Halbleitermateriales erfolgen muß. Außerdem erfordert die Implantation eine aufwendige Ausrüstung, die nicht leicht verfügbar ist. Sehr schmale als Mesa geätzte Funktionselemente lassen sich wegen der lateralen Streuung der Implantation mit diesem Verfahren nicht isolieren. Wenn die Breite der Mesa das Zweifache der Tiefe der Mesa unterschreitet, werden durch die Implantation die oberen Teile der Mesa von den unteren elektrisch isoliert, also abgeschnürt. Eine Bor-Implantation ist nur bis ca. 450 °C temperaturstabil.

Jedes einzelne Funktionselement auf dem Halbleiterbauelement durch separate Ätzung einer Mesa elektrisch von den anderen zu separieren, wie es z. B. in der Veröffentlichung von S. J. Prasad e. a.: "An Implant-Free AlGaAs/GaAs HBT IC Technology Incorporating 1.4 THz Schottky Diodes" in IEEE 1991 Bipolar Circuits and Technology Meeting 3.7, Minneapolis, Minnesota, beschrieben ist, hat den Nachteil, daß sich bei der verwendeten Fototechnik und der Bedeckung der Stufen mit Metallisierungen Probleme ergeben. Eine weitere Möglichkeit der Isolation ist durch das Ätzen von Isolationsgräben, die anschließend mit Dielektrikum (ähnlich wie bei den Oxidisolationsprozessen der bipolaren Siliziumtechnologie) gefüllt werden, gegeben. Ein solches Verfahren ist z. B. in der Veröffentlichung von G. Packeiser, H. Tews, P. Zwicknagl "High frequency AlGaAs/GaAs heterojunction bipolar transistors: the role of MOVPE", Journal of Crystal Growth 107, 883 - 892 (1991) beschrieben.

Ein anderes Verfahren besteht in der Ätzung von Mesas und dem anschließenden Auffüllen der zwischen diesen Mesas befindlichen Bereiche mit Polyimid. Die Verwendung von Polyimid als planarisierendes Material ist z. B. bei L. G. Shantharama, H. Schumacher, J. R. Hayes, C. Bhat, R. Esagui, M. Koza "Fully self-aligned microwave InP/GaInAs Single Heterojunction Bipolar Transistors", Electronic Letters 25, 127 - 128 (1989) beschrieben. Bei Verwendung von Polyimid bestehen die Nachteile in einer Oberflächenrauhigkeit und einer vorzeitigen Alterung durch hohe Feuchtigkeitsaufnahme, Schrumpfung und begrenzte Temperaturstabilität des Polyimids.

Ein Verfahren zur Planarisierung der Oberfläche eines Halbleiterbauelementes mittels eines Dielektrikums ist z. B. aus der EP 0 416 165 A1 bekannt.

Aufgabe der vorliegenden Erfindung ist es, ein Verfahren zur elektrischen Isolation eines Funktionselementes auf einem Halbleiterbauelement anzugeben, das eine planare Oberfläche des Bauelementes liefert und nicht die beschriebenen Nachteile hat.

Diese Aufgabe wird mit dem Verfahren mit den Merkmalen des Anspruches 1 gelöst. Weitere Ausgestaltungen ergeben sich aus den abhängigen Ansprüchen.

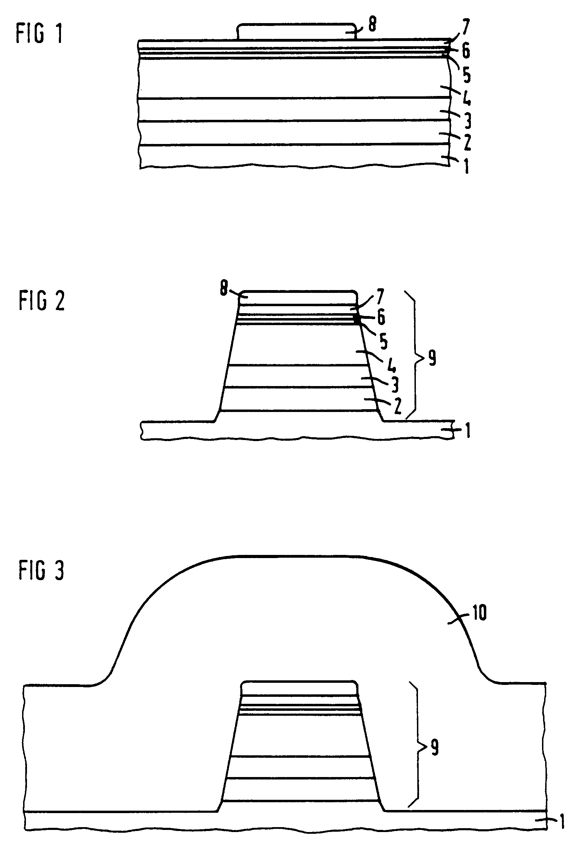

Es folgt eine Beschreibung des erfindungsgemäßen Verfahrens anhand der Figuren 1 bis 6, die ein erfindungsgemäß bearbeitetes Bauelement im Querschnitt jeweils nach verschiedenen Verfahrensschritten darstellen.

Bei dem erfindungsgemäßen Herstellungsverfahren wird zur elektrischen Isolation das Funktionselement als Mesa geätzt und mit Dielektrikum planarisiert. Das Funktionselement enthält mindestens eine mittels Implantation oder Epitaxie hergestellte hoch dotierte Halbleiterschicht. Zur veranschaulichung ist in den Figuren als Beispiel eine auf einem Substrat 1 aufgebrachte Schichtfolge dargestellt. Das kann z. B. die Schichtfolge für einen Transistor sein. In diesem Beispiel sind wie in Fig. 1 gezeigt auf das Substrat eine Pufferschicht 2, eine Subkollektorschicht 3, eine Kollektorschicht 4, eine Basisschicht 5, eine Emitterschicht 6, und eine Deckschicht 7 übereinander aufgebracht. Statt für einen Transistor kann das erfindungsgemäße Verfahren selbstverständlich für im Prinzip jedes beliebige Funktionselement angewendet werden. Im Bereich des zu isolierenden Funktionselementes wird auf die oberste Schicht (die Deckschicht 7 in Fig. 1) eine Maske 8 aufgebracht, die den Bereich des Funktionselementes abdeckt. Diese Maske wird z. B. mittels Fototechnik strukturiert. Die elektrisch leitenden Halbleiterschichten des Funktionselementes werden seitlich dieser Maske 8 weggeätzt. Es wird so die in Fig. 2 gezeichnete Mesa 9 hergestellt. In diesem Beispiel erfolgt die Ätzung bis in das Substrat 1, so daß alle Halbleiterschichten seitlich der Maske 8 weggeätzt werden. Bei einem Transistor besitzt diese Mesa 9 eine Höhe von etwa 2 bis 3 µm.

Die in Fig. 2 gezeigte Struktur wird anschließend mit einem Dielektrikum 10 wie in Fig. 3 gezeichnet ganzflächig überdeckt. Das Dielektrikum 10 wird dabei mindestens bis zu der Höhe der Mesa 9 aufgebracht, so daß das Dielektrikum 10 seitlich der Mesa 9 mindestens dieselbe Höhe wie die Mesa 9 aufweist und außerdem die Mesa 9 vollständig überdeckt. Dieses Dielektrikum ist so gewählt, daß sich an der Grenzschicht zum Halbleitermaterial keine Stromkanäle bilden und keine Sperrströme an pn-Übergängen in dem Halbleitermaterial am Rand der Schichten erhöht werden. Das Dielektrikum 10 ist außerdem temperaturstabil bis Temperaturen oberhalb 500 °C.

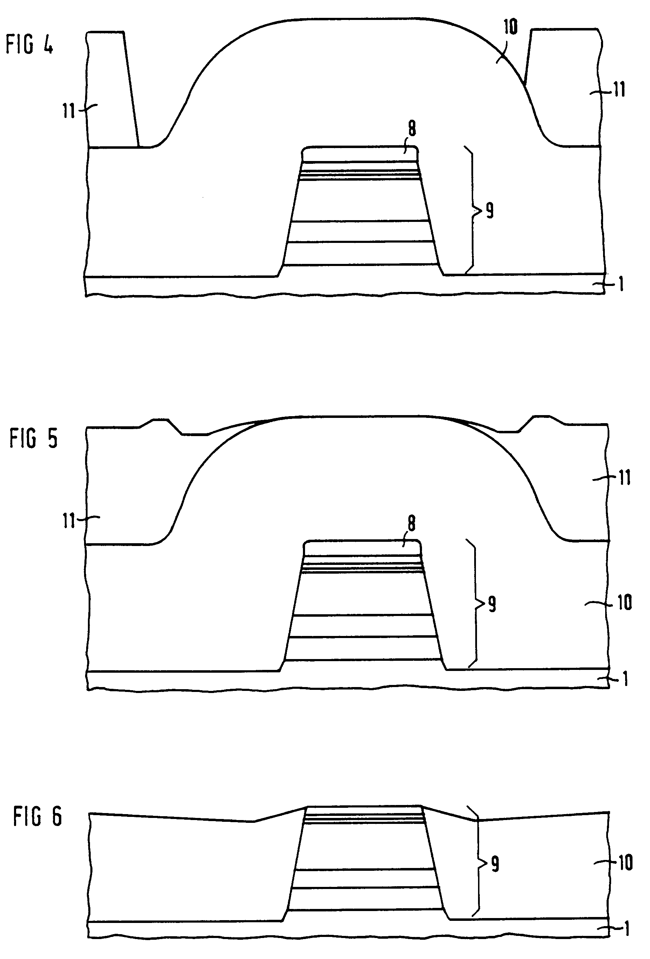

Nachfolgend werden mittels Fototechnik die tieferliegenden Gebiete des Dielektrikums 10, also die seitlich der Mesa 9 befindlichen Anteile des Dielektrikums 10, mit einem Fotolack 11 mit hohem Fließvermögen bei Temperaturbehandlung bedeckt. Als Fotolack kommt dabei z. B. Microposit 111S, Fa. Shipley Europe Ltd. in Frage. Dieser Fotolack wird etwa in einer Dicke, die der Höhe der Mesa 9 entspricht, aufgetragen. Dadurch wird sichergestellt, daß sich das Dielektrikum 10 mit diesem Fotolack 11 planarisieren läßt. Der Verfahrensschritt, in dem mittels Fototechnik dieser Fotolack 11 aufgebracht wird, ist wegen des auftretenden Selbstjustierungseffektes beim Verfließen des Fotolackes in der Justierung relativ unkritisch. Wenn der Fotolack einer Temperaturbehandlung ausgesetzt wird, verfließt dieser Fotolack wie in Fig. 5 gezeigt auf die Flanken des über der Mesa 9 befindlichen Dielektrikums 10. Auf diese Weise wird das Dielektrikum 10 durch den Fotolack 11 planarisiert. Die Struktur nach diesem Verfahrensschritt ist in Fig. 5 dargestellt.

Der Fotolack 11 und das Dielektrikum 10 werden dann mit etwa gleicher Ätzrate soweit rückgeätzt, daß die Mesa 9 freigelegt ist. Bei der in Fig. 2 angegebenen typischen Abmessung für die Höhe der Mesa 9 genügt für diesen Ätzschritt eine Toleranz in der Dicke der rückgeätzten Dielektrikumschicht von etwa 0,1 µm. Zum Ätzen wird vorzugsweise Trockenätzen (RIE oder CAIBE) angewendet. Ggf. können anschließend noch die Maske 8 und eventuell noch vorhandene Reste der einebnenden Fotolackschicht entfernt werden.

Als Material für die Maske 8 kommt Metall (z. B. Titan, Tantal) oder ein Dielektrikum (z. B. Si₃N₄, SiO₂) in Frage. Das Ätzen der Mesa geschieht vorzugsweise durch Trockenätzen (RIE oder CAIBE). Das Dielektrikum 11 ist z. B. Si₃N₄, SiON oder SiO₂. Das Ergebnis des erfindungsgemäßen Verfahrens nach dem Entfernen der Maske 8 ist in Fig. 6 dargestellt.

## Patentansprüche

1. Verfahren zur elektrischen Isolation eines Funktionselementes auf einem Halbleiterbauelement,
bei dem in einem ersten Schritt das Funktionselement zu einer Mesa (9) geätzt wird,
bei dem in einem zweiten Schritt mindestens bis zu der Höhe dieser Mesa (9) ganzflächig ein Dielektrikum (10) aufgebracht wird, das die Mesa (9) vollständig überdeckt,
bei dem in einem dritten Schritt unter Verwendung einer Maske Fotolack (11) mit hohem Fließvermögen bei Temperaturbehandlung auf die seitlich der Mesa (9) vorhandenen Anteile des Dielektrikums (10) aufgebracht werden,
bei dem in einem vierten Schritt durch Tempern die Oberfläche des Dielektrikums (10) mit dem verfließenden Fotolack (11) planarisiert wird und
bei dem in einem fünften Schritt der Fotolack (11) und das Dielektrikum (10) mit gleicher Ätzrate rückgeätzt werden, bis die Mesa (9) freigelegt ist.

2. Verfahren nach Anspruch 1 zur Herstellung eines Transistors.

3. Verfahren nach Anspruch 1 oder 2, bei dem das Dielektrikum Si₃N₄, SiON oder SiO₂ ist.

4. Verfahren nach einem der Ansprüche 1 bis 3, bei dem in dem fünften Schritt Trockenätzen angewendet wird.
